Europäisches Patentamt

European Patent Office

Office européen des brevets

(19)

(11) **EP 1 544 922 A1**

(12) **DEMANDE DE BREVET EUROPEEN**

(43) Date de publication:
**22.06.2005 Bulletin 2005/25**

(51) Int Cl.⁷: **H01L 31/042**, H01L 31/048, H01L 27/142

(21) Numéro de dépôt: **04300823.4**

(22) Date de dépôt: **29.11.2004**

(84) Etats contractants désignés:
**AT BE BG CH CY CZ DE DK EE ES FI FR GB GR HU IE IS IT LI LU MC NL PL PT RO SE SI SK TR**
Etats d'extension désignés:
**AL HR LT LV MK YU**

(30) Priorité: **15.12.2003 FR 0351060**

(71) Demandeur: **Photowatt International S.A.**
**38300 Bourgoin-Jallieu (FR)**

(72) Inventeurs:
• **Le Quang, Nam**
**38080, L'ISLE D'ABEAU (FR)**
• **Proisy, Bernard**
**69360, SOLAIZE (FR)**
• **Laporte, Michel**
**38300, MONTCEAU (FR)**
• **Dugue, Christophe**
**38110, CESSIEU (FR)**

(74) Mandataire: **Prugneau, Philippe et al**
**3 avenue Doyen Louis Weill,**
**Le Grenat,**
**EUROPOLE**
**38000 Grenoble (FR)**

(54) **Module photovoltaique avec un dispositif électronique dans l'empilage laminé**

(57)     Un module photovoltaïque (1) comprenant une ou plusieurs cellules photovoltaïques (4) reliées en série et disposées à l'intérieur d'un empilage laminé de verre et de polymère (2,3,6) et un dispositif électronique de protection (5), par exemple une diode by-pass, agencé pour dériver le courant électrique traversant au moins une cellule photovoltaïque. Le dispositif électronique de protection qui est un circuit semi-conducteur est disposé à l'intérieur de l'empilage laminé. Le circuit semi-conducteur est connecté électriquement aux cellules du module par au moins un ruban plat métallique disposé dans l'empilage laminé pour dissiper l'énergie thermique dégagée par le circuit semi-conducteur.

FIG_1

EP 1 544 922 A1

## Description

L'invention concerne un module photovoltaïque qui sert en particulier à transformer de l'énergie solaire en énergie électrique.

De tels modules photovoltaïques sont conçus actuellement pour fournir une puissance électrique comprise entre 12 et 230 W. Ils sont utilisés dans de nombreuses applications terrestre pour fournir du courant continu ou du courant alternatif. Par exemple, ils sont utilisés en sites isolés ou reliés au réseau de distribution :

- dans le réseau d'alimentation public de type EDF;
- chez les particuliers : éclairage, radio, la télévision, le petit électroménager;
- pour l'éclairage public : enseignes publicitaires, abris de bus;
- pour l'électrification rurale;
- pour le pompage;
- pour les télécommunications : infrastructure, relais GSM, poste abonné isolé;
- pour la signalisation : routière, maritime, radio, télévision.

Généralement un module photovoltaïque comprend N cellules photovoltaïques, par exemple trente-six, montées en série et reliées entres elles au moyen de rubans plats en cuivre étamé. Plus particulièrement, les cellules photovoltaïques sont des cellules photovoltaïques mono jonction fabriquées à base de silicium multi - cristallin dopé "P" avec du bore lors de la fusion du silicium et dopées "N" avec du phosphore sur leur surface éclairée. Ces cellules sont mises en place dans un empilage laminé. L'empilage laminé peut être constitué d'EVA (Ethyle Vinyle Acétate) enrobant les cellules photovoltaïques pour protéger le silicium les constituant, de l'oxydation et de l'humidité, lesdites cellules photovoltaïques étant en plus imbriquées entre une plaque de verre trempé et une feuille de polymère, par exemple en Tedlar® qui est un polyvinyle fluoride fabriqué par la société DuPont. Cette structure permet au module photovoltaïque de résister aux conditions atmosphériques et environnementales les plus sévères telles que dans les environnements tropicaux, polaires ou maritimes.

Le courant Im fourni par le module photovoltaïque est égal au courant Ic produit par chaque cellule photovoltaïque du module. Le courant Ic dépend principalement de l'éclairement et des caractéristiques physiques de la cellule telles que sa taille et la qualité du silicium la constituant. La tension Vm fournie par le module est la somme des tensions Vc de toutes les cellules photovoltaïques du module soumises à l'éclairement et est donnée par la relation :

$$Vm = S_{i=1 \text{ à } N}(Vc_i),$$

**S** désignant la fonction somme algébrique.

Dans le cas où une cellule photovoltaïque du module est ombrée, c'est à dire qu'elle ne reçoit pas la lumière à cause d'une détérioration ou parce qu'elle est recouverte d'un matériau opaque, d'une feuille d'arbre par exemple, la cellule ne fournit plus d'énergie électrique. Par contre, elle peut devenir résistante et recevoir l'énergie électrique qui est produite par les autres cellules auxquelles elle est reliée en série. Il en résulte que la tension Vo aux bornes de la cellule ombrée s'inverse et peut atteindre une tension équivalente à la somme des tensions de toutes les autres cellules du module, cette tension équivalente étant calculée par la relation suivante :

$$Vo = -S_{i=1 \text{ à } N-1} (Vc_i)$$

La puissance Wo reçue par la cellule ombrée peut atteindre la puissance maximale produite par toutes les autres cellules du module de sorte que cette cellule ombrée va chauffer ce qui peut entraîner sa destruction, ainsi que la dégradation de l'empilage laminé et du module.

Cette puissance reçue par la cellule ombrée s'exprime par la relation suivante :

$$Wo = Im^* Vo$$

Pour réduire l'échauffement des cellules ombrées et la perte d'énergie que cela engendre dans un module photovoltaïque, on utilise une diode "by-pass" qui est montée en parallèle avec un certain nombre de cellules photovoltaïques en série, par exemple dix-huit. Un module peut contenir plusieurs diodes "by-pass" reliées en parallèles respectivement à plusieurs groupes de cellules. De la sorte, une cellule ombrée est protégée car la diode by-pass se met à conduire le courant et limite la puissance reçue par la cellule ombrée. Cette dernière chauffe donc très peu mais c'est maintenant la diode by-pass qui s'échauffe. La puissance dissipée par la diode est égale au produit de la tension directe de la diode par le courant qui la traverse, ce dernier étant la différence entre le courant du circuit extérieur et le courant qui traverse la cellule ombrée. Par ailleurs, la cellule ombrée ne reçoit que la puissance fournie par les autres cellules photovoltaïques du groupe de cellules qui sont protégées par la même diode by-pass dans le module, ce qui limite son échauffement et réduit la perte d'énergie du module. Plus le nombre de cellules dans un groupe de cellules protégé par une diode by-pass est petit, plus les échauffements seront limités et la perte d'énergie faible.

Dans les modules photovoltaïques connus, les diodes by-pass sont disposées dans une boite de jonction séparée de l'empilage laminé du module. La dissipation thermique des diodes by-pass dans les boites de jonction peut être insuffisante. De plus la mise en application très prochainement d'une nouvelle norme de qualification IEC61215 Ed.2 renforce considérablement les critères de tests des diodes by-pass de protection. L'augmentation des valeurs des tests impose l'augmentation du niveau de dissipation thermique des diodes by-pass. La température des diodes by-pass placées dans la boite de jonction s'élève à des valeurs qui dépassent largement les valeurs limites autorisées.

Dans l'état actuel des réalisations il n'est pas possible de satisfaire à cette nouvelle norme sans utiliser des diodes by-pass de puissance ou sans installer des radiateurs sur les diodes by-pass, comme cela est présenté dans le brevet US6225793, ce qui augmente considérablement le coût du module.

En outre l'implantation dans les boites de jonction d'autres circuits semi-conducteurs servant au contrôle et à la commande du module du type "MOSFET" (Metal-Oxide-Silicon Field Effect Transistor), thyristor ou "GTO thyristor" ("Gate Turn Off thyristor"), augmente la complexité du câblage entre la boite de jonction et les cellules photovoltaïques.

Dans le document de brevet WO99/62125, les diodes by-pass sont montées dans l'empilage laminé sur les cellules photovoltaïques de sorte que les cellules photovoltaïques dissipent la chaleur produite par la diode by-pass mais cette dissipation thermique est insuffisante.

Le but de l'invention est de remédier aux inconvénients exposés ci-dessus en proposant un module photovoltaïque dans lequel la dissipation thermique des diodes by-pass est améliorée à moindre coût.

A cet effet, l'invention a pour objet un module photovoltaïque comprenant une ou plusieurs cellules photovoltaïques reliées en série et disposées à l'intérieur d'un empilage laminé de verre et de polymère et un dispositif électronique de protection, par exemple une diode by-pass, agencé pour dériver le courant électrique traversant au moins une cellule photovoltaïque, le dispositif électronique de protection étant un circuit semi-conducteur qui est disposé à l'intérieur de l'empilage laminé, caractérisé en ce que le circuit semi-conducteur est connecté électriquement aux cellules du module par au moins un ruban plat métallique disposé dans l'empilage laminé pour dissiper l'énergie thermique dégagée par le circuit semi-conducteur.

Cet agencement des cellules photovoltaïques et des diodes by-pass dans le module photovoltaïque permet de supprimer une partie des câblages. Il n'est plus nécessaire de faire sortir les rubans plats en cuivre de l'empilage laminé pour effectuer la protection du module photovoltaïque avec les diodes by-pass. Les rubans plats métalliques permettent d'améliorer la dissipation thermique du circuit semi-conducteur en établissant une grande surface d'échange thermique avec les éléments environnants et ainsi avec l'extérieur du module.

Selon un mode de réalisation préféré de l'invention, le circuit semi-conducteur est connecté aux cellules photovoltaïques par l'intermédiaire de deux rubans plats en cuivre.

Selon un autre mode de réalisation préféré de l'invention, le circuit semi-conducteur est une puce électronique soudée sur une cellule photovoltaïque.

Selon un autre mode de réalisation préféré de l'invention, chaque cellule photovoltaïque est insérée entre une plaque de verre et une couche de polymère, le circuit semi-conducteur de protection étant disposé entre une cellule et la couche de polymère. La diode by-pass peut alors dissiper de l'énergie thermique par la couche de polymère et par la cellule photovoltaïque qui a une bonne conductivité thermique.

Selon un autre mode de réalisation préféré de l'invention, le circuit semi-conducteur est disposé entre deux cellules photovoltaïques adjacentes.

Selon un autre mode de réalisation préféré de l'invention, le circuit semi-conducteur comprend un support multi - cristallin. Les performances des diodes by-pass n'ont pas besoin d'être très élevées et peuvent très bien être réalisées avec un coût moindre avec un support multi - cristallin.

Selon un autre mode de réalisation préféré de l'invention, le circuit semi conducteur est monté sur une plaque métallique possédant une bonne conductivité thermique, ladite plaque servant de radiateur pour dissiper l'énergie thermique.

Selon un autre mode de réalisation préféré de l'invention, le circuit semi-conducteur est intégré dans la cellule photovoltaïque, éliminant ainsi tout câblage entre cellules pour la protection du module.

Selon un autre mode de réalisation préféré de l'invention, chaque cellule photovoltaïque est munie d'un circuit semi-conducteur de protection. L'implantation d'une diode by-pass en parallèle sur chaque cellule photovoltaïque limite les problèmes liés aux cellules ombrées, car la cellule ombrée et la diode by-pass correspondante sont alors isolées et ne dissipent pas la puissance fournie par d'autres cellules. De plus, il n'y a plus besoin de créer un câblage pour mettre plusieurs cellules en parallèle avec une diode.

Selon un autre mode de réalisation préféré de l'invention, le module photovoltaïque comprend en outre de circuits de contrôle et/ou de commande des cellules photovoltaïques, et dans lequel ces circuits de contrôle et/ou de commande sont des circuits semi-conducteurs disposés à l'intérieur de l'empilage laminé. Les circuits semi-conducteurs de contrôle et/ou de commande peuvent être implantés dans l'empilage laminé pour protéger les modules photovoltaïques contre le vol ou pour gérer le droit d'accès au courant produit.

Selon un autre mode de réalisation préféré de l'invention, les circuits de contrôle et/ou de commande sont des circuits semi-conducteurs du type thyristor, MOSFET ou GTO.

Plusieurs exemples de réalisation d'un module photovoltaïque selon l'invention seront maintenant décrits plus en détail et illustrés sur les dessins annexés.

- La figure 1 est une représentation schématique d'un empilage laminé d'un module photovoltaïque selon l'invention.

- La figure 2 est une représentation très schématique vue en coupe transversale d'une partie d'un empilage laminé d'un module photovoltaïque selon l'invention.

- La figure 3 est une représentation très schématique d'un circuit semi-conducteur de protection d'un module photovoltaïque selon l'invention.

- La figure 4 est une représentation très schématique d'un circuit semi-conducteur de protection agencé sur une plaque d'un module photovoltaïque selon l'invention.

- La figure 5 est une représentation très schématique d'un circuit semi-conducteur de contrôle et/ou de commande d'un module photovoltaïque selon l'invention

- La figure 6 est une représentation très schématique de la face arrière d'un module photovoltaïque selon l'invention.

- La figure 7 est une représentation très schématique de deux cellules photovoltaïques montées en série protégées individuellement par un circuit semi-conducteur d'un module photovoltaïque selon l'invention.

- La figure 8 montre de façon très schématique un circuit semi-conducteur intégré dans la face arrière d'une cellule photovoltaïque d'un module photovoltaïque selon l'invention.

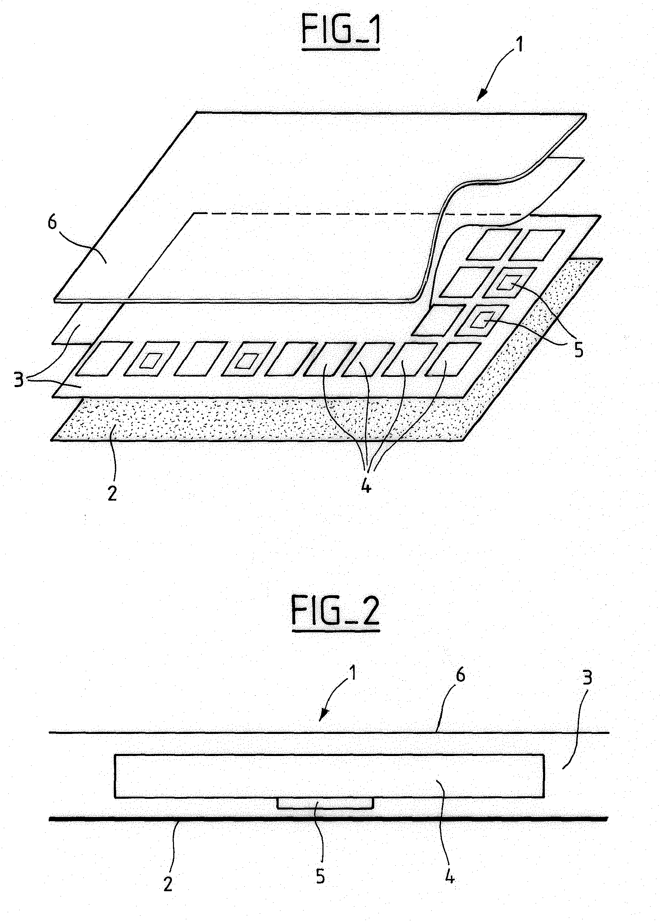

Sur la figure 1, on montre de façon schématique un empilage laminé d'un module photovoltaïque 1 selon l'invention présentant différentes couches parallèles empilées les unes sur les autres. L'arrière du module photovoltaïque 1 est formé par une couche 2 en polymère résistant qui est par exemple une feuille de Tedlar®, sur laquelle est disposé un polymère encapsulant 3, par exemple de l'EVA. A l'intérieur du polymère encapsulant sont agencées des cellules photovoltaïques 4 dans un même plan et ordonnées selon un quadrillage avec leurs faces arrière tournées vers la couche 2, ainsi que des circuits semi-conducteurs 5 placés sous certaines cellules photovoltaïques 4. Enfin sur le polymère encapsulant 3 est disposée une plaque de verre 6 formant l'avant du module photovoltaïque.

La réticulation du polymère encapsulant 3 pour fixer les cellules photovoltaïques 4 et les circuits semi-conducteurs 5 peut-être effectuée sous vide en température, environ à 150°C pour l'EVA. La couche 2 en polymère résistant assure l'étanchéité et la protection contre les dommages mécaniques, de l'arrière du module, tout en minimisant sa masse.

Sur la figure 2, on voit la disposition d'un circuit semi-conducteur 5 plat dans l'empilage laminé selon l'invention. Le circuit semi-conducteur 5 se trouve dans le polymère encapsulant 3, très proche de la couche 2 en polymère résistant.

Le circuit semi-conducteur 5 qui peut être un circuit semi-conducteur de protection (diode by-pass) peut conduire le courant lorsqu'il protège une cellule ombrée. Il dérive le courant du circuit extérieur qui ne peut pas traverser la cellule ombrée. Le circuit semi-conducteur reçoit alors de la puissance, s'échauffe et dissipe de l'énergie thermique. La dissipation thermique est facilitée par la cellule photovoltaïque 4 et la plaque de verre 6 qui ont une bonne conductivité thermique et font office de radiateur. L'énergie thermique du circuit semi-conducteur 5 est dissipée dans la cellule photovoltaïque 4 qui échange cette énergie thermique par toute sa surface avec l'encapsulant 3 et la plaque de verre 6. De plus, le polymère encapsulant 3 et la couche 2 en polymère résistant facilitent aussi la dissipation thermique du circuit semi-conducteur 5. Le circuit semi-conducteur 5 placé dans l'empilage laminé selon l'invention s'échauffe donc beaucoup moins qu'un circuit semi-conducteur similaire placé dans une boite de jonction.

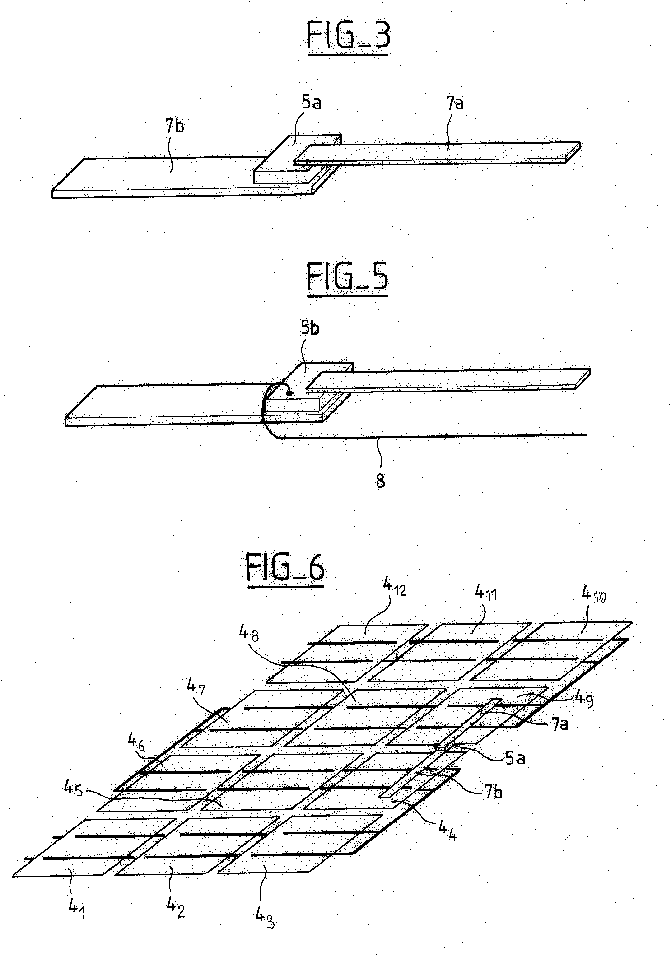

Sur la figure 3, on voit un circuit semi-conducteur de protection 5a plat (une puce électronique) qui est une diode by-pass servant à protéger le module photovoltaïque contre l'échauffement de cellules photovoltaïques ombrées. Deux rubans 7a, 7b plats métalliques, par exemple en cuivre étamé, ou composés de matériaux possédant une très bonne conductivité thermique et électrique, sont connectés (soudés) sur l'entrée et la sortie de la diode by-pass 5a. Un ruban de cuivre 7a d'épaisseur 220 micromètres et de largeur 3mm constitue l'anode et est relié à une cellule photovoltaïque non représentée présentant un potentiel plus élevé que celui de la cellule. Un ruban de cuivre 7b d'épaisseur 220 micromètres, et de largeur 5mm constitue la cathode et est relié à une autre cellule photovoltaïque non représentée présentant un potentiel inférieur à celle reliée à l'anode. Ces rubans 7a, 7b, n'ont pas la même largeur pour détromper les connexions. Lorsque des rubans ou câbles se croisent, ils sont isolés les uns des autres par des pièces ou films isolants, par exemple en EVA-Tedlar.

Les deux rubans 7a, 7b de cuivre plats disposés dans l'empilage laminé, ont une très grande surface de contact avec la diode by-pass 5a ainsi qu'une très bonne conductivité thermique. Ils permettent donc d'améliorer la dissipation thermique de la diode by-pass. La chaleur de la diode est transmise aux rubans 7a, 7b qui offrent de par leur forme plate large une très grande surface d'échange de l'énergie thermique avec les éléments environnants tels que les cellules photovoltaïques 4 auxquelles ils sont reliés, l'encapsulant 3 ou la couche en polymère résistant 2. Cette meilleure diffusion et répartition de la chaleur améliore la dissipation thermique du circuit semi-conducteur 5.

La forme plate des rubans 7a, 7b permet aussi leur meilleure insertion et intégration dans l'empilage laminé du module qui doit rester le plus fin possible.

La diode peut aussi être connectée directement entre une cellule photovoltaïque et un ruban de cuivre plat. Elle dissipera alors son énergie thermique dans la cellule et dans le ruban de cuivre.

Des tests réalisés en laboratoire montrent que l'élévation de la température d'une diode by-pass agencée selon l'invention est réduite d'environ 55% par rapport à sa valeur actuelle. Les tests consistent à appliquer sur la diode by-pass dans un environnement à 75°C un courant équivalent à 1,25 fois l'intensité maximale de fonctionnement du module 1 et à mesurer sa température. La température est alors comparée à une température limite d'utilisation pour le composant et les matériaux situés au voisinage fixée par une norme de qualification pour valider l'utilisation de ladite diode by-pass avec cette intensité maximale. Etant donné l'état actuel de la technique, il sera impossible après la mise en application de la nouvelle norme IEC61215 Ed.2 de dépasser une intensité maximale de 6A, alors que l'on a besoin actuellement de diodes by-pass fonctionnant par exemple avec une intensité maximale de 10A pour protéger les cellules photovoltaïques de 150mm par 150mm. Les diodes by-pass 5 agencées dans l'empilage laminé selon l'invention répondent aux caractéristiques techniques électriques et thermiques de la nouvelle norme et donnent la possibilité d'atteindre des intensités maximales de 15A et ainsi de satisfaire aux besoins actuels.

La figure 4 présente un circuit semi-conducteur de protection 5a agencé sur une plaque métallique 9 fine composée d'un très bon conducteur électrique et thermique, par exemple de cuivre. L'entrée ou la sortie de la diode by-pass 5a est soudée sur la plaque 9 de cuivre qui sert de connexion à un des rubans 7b de cuivre plat. L'autre borne de la diode est reliée directement à un autre ruban 7a de cuivre.

Cette plaque de cuivre 9 sert de radiateur et permet encore d'améliorer la dissipation thermique de la diode by-pass 5a en augmentant la surface d'échange de l'énergie thermique avec les éléments environnants et ainsi avec l'extérieur du module photovoltaïque 1.

Sur la figure 5, on voit un circuit semi-conducteur 5b de contrôle et/ou de commande présentant une connexion 8 filaire, optique ou électromagnétique avec l'extérieur du module. Le semi-conducteur 5b est par exemple un thyristor, un MOSFET ou un GTO. L'utilisateur du module commande et contrôle le fonctionnement du module photovoltaïque par l'intermédiaire d'un ou plusieurs semi-conducteurs tels que 5b qui se trouvent dans l'empilage laminé du module. Cet agencement permet de protéger le module photovoltaïque contre les vols. En effet pour atteindre le circuit semi-conducteur de contrôle et/ou de commande 5b qui peut servir d'interrupteur ou de coupe circuit, il est nécessaire d'ouvrir l'empilage laminé du module ce qui est une opération délicate. Le circuit semi-conducteur de contrôle et/ou de commande 5b permet aussi de gérer efficacement le droit d'accès au courant produit lorsque le module photovoltaïque est en location à péage.

La figure 6 présente l'arrière d'un module photovoltaïque et montre un agencement de douze cellules photovoltaïques $4_1$, $4_2$, $4_3$, $4_4$,..., $4_{12}$ montées en série. La face arrière de chaque cellule photovoltaïque est reliée électriquement à la face avant de la cellule photovoltaïque suivante. Entre la face arrière de la cellule $4_4$ et la face arrière de la cellule $4_9$ est connecté un circuit semi-conducteur de protection tel que 5a de la figure 3 au moyen respectivement de rubans en cuivre 7b et 7a. Le circuit semi-conducteur 5a est alors monté en parallèle avec un groupe de cellules comprenant les cellules photovoltaïques $4_5$ - $4_9$. Le circuit semi-conducteur 5a permet alors d'effectuer une protection sur les cellules photovoltaïques $4_5$ - $4_9$ du module photovoltaïque.

Comme le circuit semi-conducteur 5a est placé dans l'empilage laminé du module, il n'est pas nécessaire de faire sortir certains câbles hors de l'empilage laminé du module. Cela diminue la longueur des câbles et donc leur coût, et simplifie le câblage et donc l'opération de câblage, car moins de câbles doivent se croiser.

Sur la figure 6, on voit que les connexions électriques, par exemple les connexions entre des cellules photovoltaïques appartenant à des rangées différentes telles que la connexion entre la cellule 43 et la cellule 44, ont des portions qui s'étendent au-delà du bord latéral des cellules. On peut également concevoir un module photovoltaïque dans lequel ces portions de connexions électriques sont repliées au niveau du bord des cellules sur la face arrière du module de manière à réduire la taille du module photovoltaïque. Un film isolant, par exemple en EVA-Tedlar permet d'éviter toute interconnexion électrique entre connexions et entre connexions et cellules.

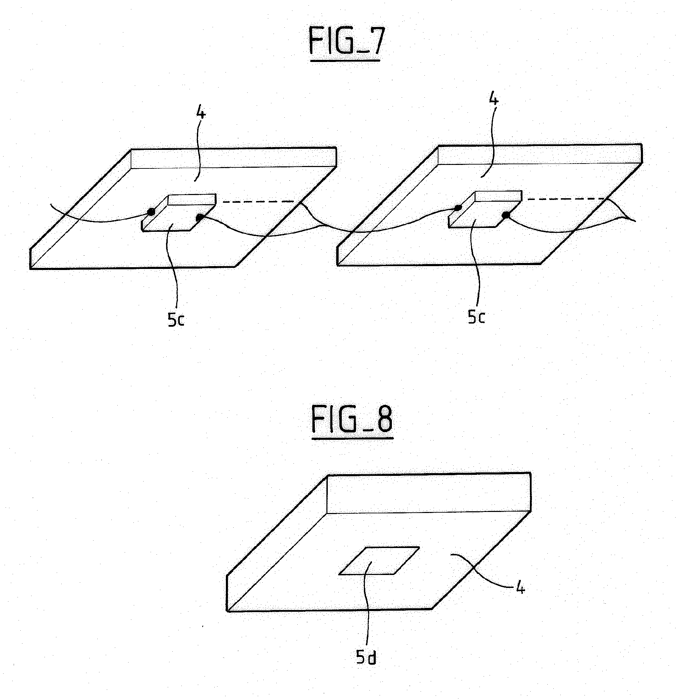

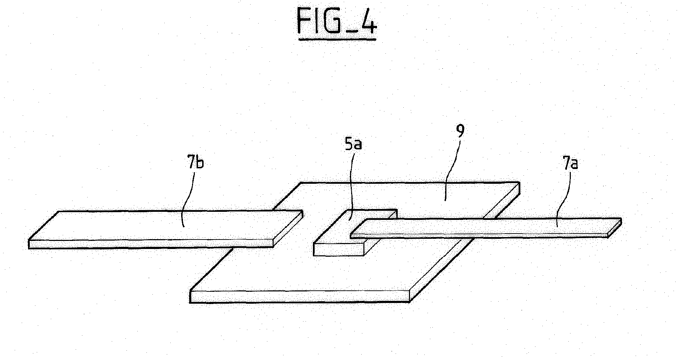

Selon l'invention, chaque cellule du module 1 peut être munie d'une diode by-pass 5c comme visible sur la figure 7. Ainsi, chaque cellule est protégée indépendamment contre des échauffements dus aux cellules ombrées. Cela permet une meilleure protection du module photovoltaïque et évite les pertes d'énergie du module par l'échauffement d'une cellule ou du semi-conducteur. Si une cellule est ombrée le courant passera par la diode by-pass mise en parallèle mais très peu d'énergie sera consommée. La puissance reçue par le semi-conducteur 5c restera limitée, ce qui évitera la dégradation de la cellule et de ce fait la dégradation du module.

De plus, aucun câblage entre les différentes cellules n'est nécessaire pour la protection du module, ce qui diminue encore la densité du câblage.

Les diodes by-pass 5c nécessaires à la protection des modules photovoltaïques n'ont pas besoin d'avoir une très bonne performances (tension inverse faible et faible courant de fuite acceptables). Ainsi il est suffisant d'utiliser des circuits semi-conducteurs de protection 5c fabriqués sur un support multi - cristallin, du même type que celui constituant les cellules photovoltaïques 4. Ces circuits semi-conducteurs 5c sont de moins bonne qualité que des puces électroniques mais surtout beaucoup moins chers et peuvent être facilement fabriqués par le constructeur des cellules photovoltaïques. Il est alors possible en utilisant des circuits semi-conducteurs 5c multi - cristallin d'implanter un circuit semi-conducteur 5c par cellule photovoltaïque 4 pour un coût raisonnable.

On voit sur la figure 7 que le circuit semi-conducteur 5c est soudé directement sur la face arrière de la cellule photovoltaïque 4. Ce mode de réalisation permet encore d'éliminer des câbles.

La soudure d'un circuit semi-conducteur 5c sur chaque cellule photovoltaïque 4 peut être réalisée à échelle industrielle de manière automatique par soudure à froid ou soudure par refusion du type CMS (Composant Monté en Surface).

Sur la figure 8, on voit un circuit semi-conducteur 5d intégré (gravé) directement sur la face arrière de la cellule photovoltaïque 4, dans le matériau la composant, c'est à dire du silicium multi - cristallin. Un circuit semi-conducteur 5d de qualité suffisante est préalablement intégré sur la cellule photovoltaïque 4, ce qui réduit les opérations de fabrication du module photovoltaïque en éliminant des soudures.

L'invention permet de réduire le coût des câblages du module, car 30 à 50% des câblages peuvent ainsi être supprimés. Le gain de place généré par la suppression de câblages permet une diminution de la taille du module.

L'invention permet aussi d'améliorer la dissipation thermique des circuits semi-conducteurs et ainsi de répondre aux exigences de la nouvelle norme IEC61215 Ed.2.

## Revendications

1. Module photovoltaïque (1) comprenant une ou plusieurs cellules photovoltaïques (4) reliées en série et disposées à l'intérieur d'un empilage laminé de verre et de polymère (2, 3, 6) et un dispositif électronique de protection (5), par exemple une diode by-pass, agencé pour dériver le courant électrique traversant au moins une cellule photovoltaïque, le dispositif électronique de protection étant un circuit semi-conducteur qui est disposé à l'intérieur de l'empilage laminé, **caractérisé en ce que** le circuit semi-conducteur est connecté électriquement aux cellules du module par au moins un ruban plat métallique (7a ; 7b) disposé dans l'empilage laminé pour dissiper l'énergie thermique dégagée par le circuit semi-conducteur.

2. Module photovoltaïque selon la revendication 1, dans lequel le circuit semi-conducteur est connecté aux cellules photovoltaïques par l'intermédiaire de deux rubans plats en cuivre (7a, 7b).

3. Module photovoltaïque selon la revendication 1, dans lequel le circuit semi-conducteur est une puce électronique soudée sur une cellule photovoltaïque.

4. Module photovoltaïque selon l'une des revendications précédentes, dans lequel chaque cellule photovoltaïque (4) est insérée entre une plaque de verre (6) et une couche de polymère (2), le circuit semi-conducteur de protection (5) étant disposé entre une cellule (4) et la couche de polymère (2).

5. Module photovoltaïque selon l'une des revendications 1 et 2, dans lequel le circuit semi-conducteur est disposé entre deux cellules photovoltaïques adjacentes.

6. Module photovoltaïque selon l'une des revendications précédentes, dans lequel le circuit semi-conducteur (5) comprend un support multi - cristallin.

7. Module photovoltaïque selon l'une des revendications précédentes, dans lequel le circuit semi conducteur est monté sur une plaque métallique (9) possédant une bonne conductivité thermique, ladite plaque servant de radiateur pour dissiper l'énergie thermique.

8. Module photovoltaïque selon la revendication 1, dans lequel le circuit semi-conducteur est intégré (5d) dans la cellule photovoltaïque.

9. Module photovoltaïque selon l'une des revendications précédentes, dans lequel chaque cellule photovoltaïque (4) est munie d'un circuit semi-conducteur de protection (5).

10. Module photovoltaïque selon l'une des revendications précédentes, comprenant en outre de circuits de contrôle et/ou de commande (5b) des cellules photovoltaïques, et dans lequel ces circuits de contrôle et/ou de commande sont des circuits semi-conducteurs disposés à l'intérieur de l'empilage laminé.

**11.** Module photovoltaïque selon la revendication 10, dans lequel les circuits de contrôle et/ou de commande sont des circuits semi-conducteurs du type thyristor, MOSFET ou GTO.

# FIG_1

# FIG_2

# FIG_3

# FIG_5

# FIG_6

## FIG_7

4

4

5c

5c

## FIG_8

4

5d

## FIG_4

# EP 1 544 922 A1

Office européen
des brevets

**RAPPORT DE RECHERCHE EUROPEENNE**

Numéro de la demande

EP 04 30 0823

## DOCUMENTS CONSIDERES COMME PERTINENTS

| Catégorie | Citation du document avec indication, en cas de besoin, des parties pertinentes | Revendication concernée | CLASSEMENT DE LA DEMANDE (Int.Cl.7) |
|---|---|---|---|
| Y | EP 1 079 441 A (KANEGAFUCHI CHEMICAL IND) 28 février 2001 (2001-02-28) * figures 7,8 * ----- | 1-11 | H01L31/042 H01L31/048 H01L27/142 |
| Y | US 6 225 793 B1 (DICKMANN PETER) 1 mai 2001 (2001-05-01) * colonne 1, ligne 25-38 - colonne 5, ligne 26-33 * ----- | 1-11 | |
| A | WO 99/62125 A (TECSTAR POWER SYSTEMS INC ;CHU CHAW LONG (US); HO FRANK (US); ILES) 2 décembre 1999 (1999-12-02) * page 7, ligne 19 - page 8, ligne 23; figures 13A,13B,14B * ----- | 1-11 | |
| A | US 6 103 970 A (DEWITT MARK  ET AL) 15 août 2000 (2000-08-15) * abrégé * ----- | 1 | |
| A | US 6 317 327 B1 (LIN CHIN-FENG) 13 novembre 2001 (2001-11-13) * abrégé * ----- | 1 | **DOMAINES TECHNIQUES RECHERCHES (Int.Cl.7)** H01L |

Le présent rapport a été établi pour toutes les revendications

| Lieu de la recherche | Date d'achèvement de la recherche | Examinateur |
|---|---|---|
| Munich | 14 février 2005 | Werner, A |

EPO FORM 1503 03.82 (P04C02)

**ANNEXE AU RAPPORT DE RECHERCHE EUROPEENNE
RELATIF A LA DEMANDE DE BREVET EUROPEEN NO.**

EP 04 30 0823

La présente annexe indique les membres de la famille de brevets relatifs aux documents brevets cités dans le rapport de recherche européenne visé ci-dessus.
Lesdits members sont contenus au fichier informatique de l'Office européen des brevets à la date du
Les renseignements fournis sont donnés à titre indicatif et n'engagent pas la responsabilité de l'Office européen des brevets.

14-02-2005

| Document brevet cité au rapport de recherche | | Date de publication | Membre(s) de la famille de brevet(s) | | Date de publication |
|---|---|---|---|---|---|
| EP 1079441 | A | 28-02-2001 | JP | 2001068713 A | 16-03-2001 |
| | | | JP | 2001068696 A | 16-03-2001 |
| | | | JP | 2001085709 A | 30-03-2001 |
| | | | JP | 3246732 B2 | 15-01-2002 |
| | | | JP | 2001085719 A | 30-03-2001 |
| | | | AU | 767581 B2 | 20-11-2003 |
| | | | AU | 2061300 A | 01-03-2001 |
| | | | EP | 1079441 A2 | 28-02-2001 |
| | | | US | 6288323 B1 | 11-09-2001 |
| US 6225793 | B1 | 01-05-2001 | DE | 19916742 C1 | 24-08-2000 |
| | | | EP | 1045455 A2 | 18-10-2000 |
| | | | JP | 2000315808 A | 14-11-2000 |
| WO 9962125 | A | 02-12-1999 | WO | 9962125 A1 | 02-12-1999 |
| | | | AU | 4193899 A | 13-12-1999 |
| | | | EP | 1008188 A1 | 14-06-2000 |
| | | | JP | 2002517098 T | 11-06-2002 |
| US 6103970 | A | 15-08-2000 | AU | 5131299 A | 14-03-2000 |
| | | | EP | 1110247 A1 | 27-06-2001 |
| | | | JP | 3448743 B2 | 22-09-2003 |
| | | | JP | 2002523903 T | 30-07-2002 |
| | | | WO | 0011724 A1 | 02-03-2000 |
| | | | US | 6326540 B1 | 04-12-2001 |
| | | | US | 2002144724 A1 | 10-10-2002 |
| US 6317327 | B1 | 13-11-2001 | AUCUN | | |

EPO FORM P0460

Pour tout renseignement concernant cette annexe : voir Journal Officiel de l'Office européen des brevets, No.12/82